# EUROPEAN PATENT SPECIFICATION

(11) **EP 4 009 364 B1**
(45) Date of publication and mention of the grant of the patent: **25.10.2023**
(21) Application number: 20211556.4
(22) Date of filing: 03.12.2020
(51) Int. Cl.: H01L 23/473

(54) **ARRANGEMENT OF A POWER SEMICONDUCTOR MODULE AND A COOLER**
ANORDNUNG EINES LEISTUNGSHALBLEITERMODULS UND EINEM KÜHLER
AGENCEMENT D'UN MODULE SEMI-CONDUCTEUR DE PUISSANCE ET UN REFROIDISSEUR

(43) Date of publication of application: 08.06.2022
(73) Proprietor: Hitachi Energy Switzerland AG, 5400 Baden (CH)
(72) Inventor: Pavlicek, Niko, 8041 Zürich (CH); Schuderer, Juergen, 8047 Zürich (CH); Loisy, Jean-Yves, 5452 Oberrohrdorf (CH); Mohn, Fabian, 5408 Ennetbaden (CH); Gradinger, Thomas, 5032 Aarau Rohr (CH)
(74) Representative: Epping - Hermann - Fischer

(56) References cited:
- DE-A1-102015 215 682
- JP-A- 2006 165 186
- JP-A- 2012 079 950
- JP-A- 2015 193 263
- JP-A- 2016 092 209
- JP-A- 2016 119 427
- JP-A- 2016 146 451
- JP-A- 2019 179 807
- US-B1- 7 215 545

## Description

The present disclosure relates to an arrangement of a power semiconductor module and a cooler. The present disclosure relates to a power semiconductor module having an improved connection to a cooler by means of an adhesive. The present disclosure further relates to a method for forming such an arrangement.

Document JP 2016 146451 A describes a semiconductor device with a cooler.

Document JP 2016 092209 A describes a power semiconductor device, and method of manufacturing the same.

Document JP 2015 193263 A describes a manufacturing method of a complex type hollow container.

Document US 7 215 545 B1 describes a liquid cooled diamond bearing heat sink.

Document DE 10 2015 215682 A1 describes a cooling device and a power electronic assembly with a cooling device.

Document JP 2019 179807 A describes a water passage device, a water-cooling cooler and an electric power conversion device.

Document JP 2006 165186 A describes a power semiconductor device where a plurality of semiconductor modules are cooled in a heat sink.

Document JP 2012 079950 A describes a semiconductor cooling device and document JP 2016 119427 A describes an electronic apparatus.

Power modules in inverters of electric cars, for example, are typically cooled by a cooling liquid, such as mixture of glycol and water. To this end, the modules need to be mounted on a cooling unit. The thermal resistance needs to be minimized to save expensive semiconductor material, such as wide-bandgap SiC, prohibiting the use of thermal interface material. Direct cooling by means of baseplates with integrated pin-fins in direct contact to the cooling liquid is, for example, desired.

For example, power modules are screwed onto open cooling structures using O-rings or gaskets as a sealing. Alternatively, power modules without integrated cooling structure, for example, baseplate-less modules, can be mounted or bonded on a closed cooler. The latter approach leads to the technical requirement of a reliable bond between module and cooler with high thermal conductivity. Soldering or sintering might be employed, but such techniques require elevated process temperatures possibly causing mold delamination for power modules that are already encapsulated prior to the attachment to a cooler.

US 2019/096787 A1 describes a power semiconductor package having a base plate with a first surface and an opposing second surface. At least one power semiconductor module can be mounted to the first surface of the base plate. A cooling structure having at least one cooling channel for containing a cooling liquid therein is disclosed. A contact rim is arranged around a perimeter of the cooling channel and configured to receive an adhesive. The contact rim is affixed parallel to and abutting against the second surface of the base plate thereby forming a hermetic seal at the adhesive. A power converter and method for attaching and sealing a semiconductor cooling structure in a semiconductor package is also disclosed.

US 2007/145576 A1 describes a power semiconductor circuit having a power semiconductor module provided in the form of a flat module. In order to utilize the design possibilities resulting therefrom and to provide a power semiconductor circuit that has an automatable production and a space-saving design, the flat module, with its substrate, is glued by a heat conducting adhesive directly onto a heat conducting base plate that acts as a cooling element.

However, providing a power semiconductor module with a cooler is still an issue.

Embodiments of the disclosure addresses the above shortcomings in the art in whole or in part, as further explained below.

These are addressed at least in part by an arrangement having the features of independent claim 1. These are further addressed at least in part by a method having the features of independent claim 7.

This is, the invention is defined by the attached set of claims. Advantageous embodiments are given in the dependent claims, in the further description as well as in the Figures, wherein the described embodiments can, alone or in any combination of the respective embodiments, provide a feature of the present disclosure unless clearly excluded.

Described is an arrangement comprising a power semiconductor module, a cooler for cooling the power semiconductor module, and an adhesive for fixing the cooler to the power semiconductor as claimed in claim 1.

Such an arrangement may provide advantages over the cited prior art, exemplarily with regard to connecting the cooler to the power semiconductor module.

The arrangement comprises a power semiconductor module, a cooler for cooling the power semiconductor module, and an adhesive for fixing the cooler to the power semiconductor module. For example, the power semiconductor module comprises an electrical circuit with at least one power semiconductor device.

The power module has, for example, a main plane of extension. Lateral directions are aligned parallel to the main plane of extension and a vertical direction is aligned perpendicular to the main plane of extension.

The power semiconductor device can further comprise at least two semiconductor chips, which require cooling. For example, the baseplate carries a substrate for an electrical circuit. The two semiconductor chips are arranged on the substrate, exemplarily the same substrate. For example, one of the semiconductor chips is formed as a switch and the other of the semiconductor chips is formed as a diode. In this case, the switch and the diode are connected antiparallel to one another. The two semiconductor chips being connected antiparallel to one another form, for example, a half bridge. For example, the power semiconductor module comprises one or more half bridges.

The power semiconductor module is used, for example, in an inverter of an electric car. For example, the inverter is a key component within an electric drivetrain. Battery-powered electric vehicles typically use three-phase two-level inverters often consisting of three individual half-bridge (HB) power modules. Instead of mounting the HB modules to a cooling unit by screwing and sealing with gaskets (O-rings) as done in the prior art, the power semiconductor module of the arrangement according to the disclosure is adhesively bonded to the cooler.

The power semiconductor module comprises a baseplate. Exemplarily, the baseplate has a first main surface at a first side facing away from the cooler. The substrate is arranged in this case on the first main surface. The first main surface extends in lateral directions. Furthermore, the first main surface is formed plan, for example.

The baseplate may be formed from a metal or a metal matrix composite as it is generally known in the art. It is adapted for dissipating heat from the substrate and its electrical circuit such as its power semiconductor devices, for example. Accordingly, the baseplate carries a substrate for an electrical circuit at its first main surface, for example. Exemplarily, the electric circuit with its chips may be positioned on a substrate metallization and require cooling.

The power semiconductor module further comprises a cooling structure with a cooling surface, wherein the cooling surface faces the cooler for dissipating heat from the baseplate. Further, according to the embodiment, the cooling structure is at least in part formed from the baseplate, wherein the cooling surface faces the cooler for dissipating heat from the baseplate and the cooling structure is at least in part formed from the baseplate. For example, the cooling surface at a second side of the baseplate is located opposite to the first side. The cooling surface is exemplarily adapted to be in contact with the cooler. Furthermore, the power module is cooled by a thermal contact to the cooling surface. For example, the cooling surface is at least in part in direct contact with a coolant of the cooler.

The cooling structure comprises an inner area and an outer area surrounding the inner area at least in part in lateral directions and comprising a first connecting area in the outer area. The inner area is configured, for example, as a cooling area for dissipating heat from the cooling structure. The outer area surrounding the inner area at least in part in lateral directions comprises a first connecting area.

The cooling structure is, for example formed of the base plate. A further layer can be provided on the base plate at the second side. In this case, the cooling structure is formed of the base plate and the further layer. The further layer can cover the base plate at the second side completely or in part in the inner area. If the base plate is covered in part by the further layer in the inner area, the cooling surface is formed in part of the baseplate and in part by of the further layer. If the base plate is covered completely by the further layer in the inner area, the cooling surface is formed of the further layer. The further layer can be any layer which has a thermal conductivity suitable for dissipating heat.

The inner area is configured exemplarily to be active in cooling, so that the heat transfer is only or mainly realized in the inner area. For example, the inner area is in direct contact with the coolant when the coolant flows through a cooling channel of the cooler as described in detail below. Further, the outer area is configured, for example, for being connected to other elements, as described in detail below.

For example, the cooler is provided for dissipating heat from the power semiconductor module and with this regard from the power semiconductor devices, i.e. the power semiconductor chips. The cooler is exemplarily adapted for direct cooling and thus for dissipating heat from the power semiconductor module by the coolant, exemplarily a cooling liquid, such as a mixture of water and glycol.

The cooler exemplarily comprises a cooling channel for receiving the coolant. In this case, the cooler may be an open cooler which has the cooling channel in the inner area for guiding the coolant, wherein the cooling channel is open at least in part to the side which is adapted to be connected to the baseplate. Thus, if the coolant flows through the cooling channel, the coolant is in direct contact e.g. to the cooling structure and may thus effectively cool the baseplate and correspondingly the power semiconductor module.

The first connecting area is connected to a second connecting area of the cooler via the adhesive. The power semiconductor module is connected to the cooler, for example, in the outer area, so that the first connecting area and the second connecting area are in contact with each other via the adhesive for fixing the cooler to the power semiconductor module.

The first connecting area comprises a first connecting structure and the second connecting area comprises a second connecting structure.

The adhesive is placed between the first connecting structure and the second connecting structure.

The adhesive used may generally be chosen according to the desired needs and depending on the material of the cooling structure, e.g. the baseplate. Examples for suitable adhesives comprise resins based on epoxides, silicones, polyurethanes, acrylics, polycyanates, polyimides, polybenzocyclobutanes and benzoxaxines. Examples for applying the adhesive to the respective connecting area comprise dispensing, jetting, screen/stencil printing, and tool transfer. For example, such adhesives allow bonding between dissimilar materials, such as Ni-plated Cu, e.g. used for the baseplate, for high thermal conductivity and Al, used for the cooler, for low cost and minimized weight, which might be required for existing power modules.

For example, the adhesive is in direct contact to the power semiconductor module, to the cooler or to both of the power semiconductor module and the cooler. In addition, the adhesive extends up to the cavity in lateral directions such that the adhesive is in indirect contact with the coolant.

According to at least one embodiment of the arrangement, at least one of the first connecting area and the second connecting area comprise a flat surface area. For example, the first connecting area and the second connecting area each comprises at least a first area and a second area. The first area is exemplarily formed of the flat surface area and the second area is exemplarily formed of at least one of the first connecting structure and the second connecting structure. The adhesive is provided at least in part at the first area and at least in part at the second area for fixing the first connecting area to the second connecting area.

For example, both of the first connecting area and the second connecting area comprise the first area in which the cooler as well as the cooling surface is flat, thus extending in lateral directions. The first areas of the cooler and the power module, for example, face each other. The first area has a surface, i.e. the flat surface area, extending parallel to the lateral directions and may define a connecting plane.

The flat surface area exemplarily comprises roughness values Rz of 10 µm < Rz < 50 µm, where Rz corresponds to the maximum height of a measured profile on a surface, which might be determined by peak to peak measurement.

At the second area, at least one of the first connecting area has a first connecting structure and the second connecting area has a second connecting structure, for example.

Generally, a connecting structure, e.g. the first connecting structure and the second connecting structure, is a structure which deviates from a flat surface and which thus shows locations at which the surface is not in the connection plane. For example, a surface of the connecting structures may be aligned at least in part with an angle to the connection plane. As an example, the connecting structure may at least in part extends orthogonally with regard to the connecting plane.

The arrangement as described allows advantages over solutions of the prior art. In detail, due to the fact that a fixation between the power module and the cooler is realized by means of an adhesive, a bond mediated by the adhesive provides both mechanical strength and at least locally a leak-tight seal preventing leakage of the coolant fluid. Thus, the mechanical fixation provides at least locally a leak-tight seal between the power semiconductor module and the cooler.

This is of importance as a leak-tight bond mediated by the adhesive between the baseplate with integrated cooling structure of the power semiconductor modules and the cooler is generally required as leakage of the cooling liquid must be prevented throughout the lifetime of the arrangement, for example.

Thus, the adhesive is, for example, a mechanical fixation and at least in part or even a completely leak-tight sealing, thereby being, e.g., cost-conscious.

Further, this solution allows increasing a power density, being the power per volume, of the power semiconductor module, such as of the inverter, due to the following reasons.

The required space of mounting overhead such as required for screws, threaded holes, alignment or assembly parts, can be saved and further, a semiconductor area can be saved because the thermal path can be optimized without additional constraints by the module-to-cooler bond. Thus, the space which is available may be optimized for placing chips thereon.

In addition to the saved semiconductor area, the cost of the power semiconductor module, such as an inverter, also decreases. This may be due to the fact that adhesive bonding processes can be fully automated, and further, adhesive material is cheap and thus fixing the cooler to the power module may be cheaper compared to traditional ways such as by using screws and additional sealings.

Furthermore, the adhesive bonding can be well integrated into the module manufacturing process. Curing of the adhesive can be conducted as a batch process at typically lower than 150 °C or even at room temperature. Thereby, delamination issues of mold compounds of bonding large-size mold compound modules by soldering or sintering is solved.

Thus, connecting the cooler to the power module can be readily automated, reduces the number of parts, reduces the number of manufacturing steps, and thereby reduces the cost of the inverter. Additional features on the baseplate and/or the cooler are configured to promote adhesive bonding and, moreover, to reduce the dimensioning tolerances of the cooler assembly.

In fact, by the first connecting structure and the second connecting structure, the surfaces of the outer area which are in contact with the adhesive may be enlarged, so that the bonding strength is improved. Thus, the mechanical fixation is also improved leading to an enhanced long-term reliability.

Apart from that, for example, in case the first connecting area and the second connecting area comprise the first connecting structure and the second connecting structure, respectively, this solution allows a very precise position of the cooler relative to the power semiconductor module. In this case, the first connecting structure and the second connecting structure pre-set a defied position of the cooler relative to the power module.

Therefore, the first connecting structure and the second connecting structure may allow an improved mechanical fixation with a defined position of the cooler relative to the power semiconductor module. An adequate position of the cooler may further improve the cooling efficiency and may improve homogeneous cooling of all power semiconductor devices of the power semiconductor module.

Exemplarily, either one or both of the first contact area and the second contact area may be roughened. This measure already enhances the contact between the first contact area and the second contact area to the adhesive so that the bonding strength may be enhanced. Such a measure may be taken by means of machining, mechanical deformation, mechanical treatment like sand blasting, or plasma treatments etc. It is found that, for example, surfaces having roughness values Rz of equal or more than 50 µm may help to enhance bonding strength and thus the fixation of the cooler at the power module, leading to an improved mechanical fixation and long-term reliability of the arrangement.

The first connecting structure is arranged opposite to the second connecting structure Exemplarily, a very strong interaction between the first connecting area and the second connecting area and the adhesive results. Thus, the bonding strength may be effectively improved.

The first connecting structure and the second connecting structure being arranged opposite each other each have, for example a shape, configured to fit in each other, such as protrusions and recessions. These protrusions and recessions are arranged such that the protrusions are arranged in the recessions. In other words, the first connecting structure may be positioned adjacent to and within the second connecting structure, or vice versa.

At least one of the first connecting structure comprises at least one recession and the second connecting structure may comprise at least one protrusion, and the first connecting structure comprises at least one protrusion and the second connecting structure may comprise at least one recession.

For example, the first connecting structure or the second connecting structure comprises at least one recession and the second connecting structure or the first connecting structure comprises at least one corresponding protrusion.

According to at least one embodiment of the arrangement, at least one of the first connecting structure and the second connecting structure form a closed path surrounding the inner area in lateral directions. This is to say that at least one of the first connecting structure and the second connecting structure surround the inner area completely in lateral directions.

According to this embodiment, the connection between the cooler and the baseplate may be secure, for example, due to the size of the area which is provided with an adhesive and due to the size of the first connecting structure and the second connecting structure. Apart from that, in case the closed path surrounds the whole inner area in lateral directions, e.g. the cooling area, the baseplate is sealed against the cooler completely in the region of the first connecting structure and the second connecting structure so that no further sealing has to be required. Further, as the bonding strength of the adhesive at the first connecting structure and the second connecting structure is strong, for example, the risk of a damage of the adhesive and thus a leak to appear is reduced, leading to a high long-term reliability. Thus, the provision of O-rings with using screws can be avoided safely which might lead to an improved reliability. Further, space is saved as no groove is required for the O-ring and threaded holes for the screws.

Therefore, this embodiment allows a secure and reliable fixation of baseplate and cooler, thereby effectively avoiding components for manufacturing the latter. According to at least one embodiment of the arrangement, the first connecting area comprises a plurality of first connecting structures and the second connecting area comprises a plurality of second connecting structures, wherein the first connecting structures and the second connecting structures are aligned differently. Therefore, a correct position in which the baseplate and the cooler being fixed to each other is exemplarily reliable. Thus, a positioning of the baseplate relative to the cooler may be very precise, which allows connecting the cooler to the baseplate in a defined manner. Apart from that, the first connecting structures and the second connecting structures may receive forces which act against the fixation effectively, so that the load of the adhesive may be reduced at least in part.

According to at least one embodiment of the arrangement, the first connecting area is part of a mold compound being arranged on the baseplate.

For example, the power semiconductor module comprises a mold compound being arranged on the power semiconductor devices. The mold compound is configured, for example, to encapsulate the power semiconductor devices. In this case, the mold compound and the substrate encapsulate the semiconductor devices three dimensionally. The mold compound is arranged between the base layer and the cooler. Thus, the mold compound comprises the first connecting area in the outer area. With this regard, it may be allowed that the present disclosure may be incorporated into existing processes especially easily. This may be due to the fact that the baseplate may be a conventional one and the connecting structure has to be provided in the mold compound. This may be achieved easily by providing respective mold parameters.

According to at least one embodiment of the arrangement, the cooler comprises an inlet port and an outlet port, and wherein the cooler comprises a cooling channel for guiding coolant between the inlet port and an outlet port within the inner area. For example, the coolant can flow from the inlet port through the cooler, e.g. through the cooling channel, to the outlet port. Exemplarily, the coolant is pumped from the inlet port via the cooling channel to the outlet port.

According to at least one embodiment of the arrangement, the cooling structure is arranged within the cooling channel. For example, the cooling structures comprise pin fins. For example, the pin fins extend in vertical direction, wherein the tips of the pin fins face away from the power semiconductor module. The pin fins have a cross sectional shape in lateral directions of a circle, an ellipse, or a rhombus. Alternatively, the cooling structure comprise lamellas. The lamellas extend in vertical direction, wherein the tips of the pin fins face away from the power semiconductor module. In addition, the lamellas extend in lateral directions at least up to 20 % along a width or a length of the base plate. The cooling structure are formed, for example, from the same material as the base plate, such as Cu. Exemplarily, the cooling structure and the base plate are formed integrally with one another.

For example, the pin fins or the lamellas increase an area of the bottom surface of the base plate. Advantageously, heat dissipation can be improved because of such pin fins or the lamellas.

With regard to further advantages and technical features of the arrangement, it is referred to the method, the Figures and the further description.

Further described is a method for forming an arrangement according to claim 7.

Such a method allows connecting a cooler to a power semiconductor module in an easy manner, thereby allowing an effective cooling, a reliable mechanic connection and a simplified sealing.

According to at least one embodiment of the method, before applying the adhesive according to step b), at least one of a first area of the first connecting area and a first area of the second connecting area is roughened. With this regard, at least one of the first connecting area and the second connecting area, e.g. of at least one of the baseplate and of the cooler, may be roughened. Additionally, the roughening may be performed at the surface which is provided with an adhesive afterwards.

Such a roughening may be useful for improved adhesion properties of the respective surface and thus for an improved mechanical connection.

According to at least one embodiment of the method, roughening is performed with at least one of a chemical process, such as wet chemical cleaning, degreasing and chemical priming/activation, and a process such as mechanical machining, deformation and roughening. With such processes, a roughened surface can be achieved. This processes can be followed by at least one of the following processes: drying, baking, plasma treatment.

With regard to further advantages and technical features of the arrangement, it is referred to the method, the Figures and the further description.

These and other aspects of the disclosure will be apparent from and elucidated with reference to the embodiments described hereinafter. Individual features disclosed in the embodiments can constitute alone or in combination an aspect of the present disclosure. Features of the different embodiments can be carried over from one embodiment to another embodiment.

In the drawings:
Fig. 1 shows a schematic sectional view of an arrangement according to an example of the disclosure;
Fig. 2 shows a detailed view of the arrangement according to Figure 1;
Fig. 3 shows a further detailed view of the arrangement according to Figure 1;
Fig. 4 shows a schematic sectional view of an arrangement according to a further exemplary embodiment of the disclosure;
Fig. 5 shows a detailed view of the arrangement according to Figure 4;
Fig. 6 shows a further detailed view of the arrangement according to Figure 4;
Fig. 7 shows a view onto an arrangement according to the disclosure; and
Fig. 8 shows a detailed view of a feature of an example of the arrangement according to the disclosure.

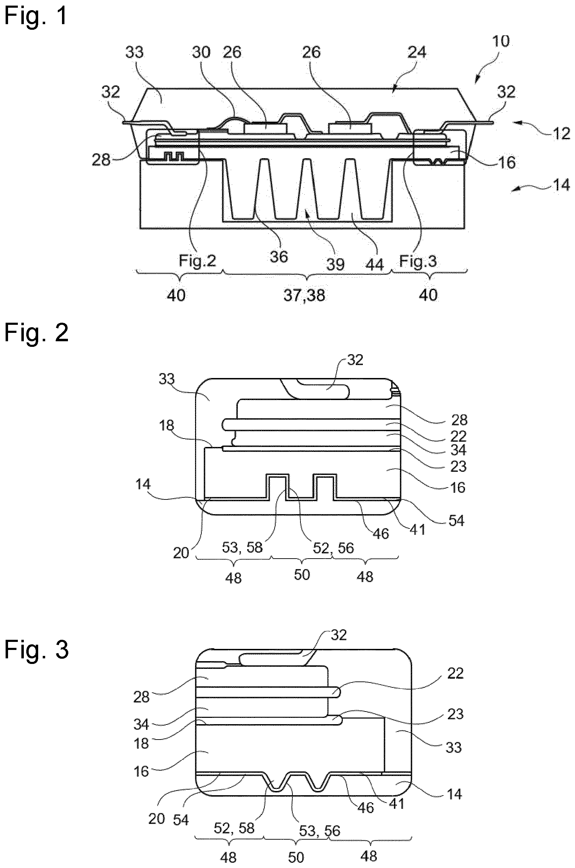

This is, that Figures 1, 2, 3 and 8 solely refer to examples as indicated for better comprehensibility of the disclosed arrangements.

Figure 1 shows an arrangement 10 of a power semiconductor module 12 and a cooler 14 not falling under the scope for which protection is sought. Such an arrangement 10 may for example form an inverter and may be used in electrically-driven vehicles, for example.

The power semiconductor module 12 comprises a baseplate 16 having a first main surface at a first side18 and having a second side 20, the second side 20 being located opposite to the first side 18. The baseplate 16 carries at its first main surface at the first side 18 a substrate 22 for an electrical circuit 24. The electrical circuit 24 comprises power semiconductor devices 26 which are positioned on respective substrates 22 via substrate metallizations 28. Further, the power semiconductor devices 26 are connected to metallizations 28 via bond wires 30, such as clips, ribbons or bond lines. Further shown are terminals 32 for externally contacting the power semiconductor module 12.

With regard to a connection of the substrate 22 to the baseplate 16, it is shown that these components are fixed to each other by a further metallization 34. However, fixing the baseplate 16 to the substrate 22 may generally be done according to the prior art.

Further, in order to protect the electrical circuit 24, it is shown that the latter is embedded in a mold compound 33, which might be an epoxy mold compound and which forms an encapsulation.

It is further shown that the power semiconductor module 12 further comprises cooling structure 39 with a cooling surface 36 which faces the cooler 14. The cooling surface 36 is adapted for being in contact with a coolant within the cooler 14, wherein the cooling structure 39 is at least in part formed by the baseplate 16 at its second side 20. The cooling structure 39 comprises an inner area 38 being configured as a cooling area 37 for dissipating heat from the baseplate 16. The cooling structure 39 further comprises an outer area 40 being configured as first connecting area 41 for being connected to the cooler 14. The outer area 40 completely surrounds the inner area 38 in lateral directions.

The cooler 14 comprises a cooling channel 44 which defines a cooling channel for receiving a coolant. The cooler 14 comprises a second connecting area 46 for being connected to the power semiconductor module at its first connecting area 41. Figure 1 further shows that the first connecting area 41 comprises first connecting structures 52 and the second connecting area 46 comprises second connecting structures53. In more detail, the first connecting area 41 and the second connecting area 46 both comprise two first areas 48 and a second area 50. At the first areas 48 the cooler 14 and the power semiconductor module 12 have a flat surface area opposite one another. At the second area 50 the cooler 14 and the power semiconductor module 12 have the first connecting structures 52 and the second connecting structures 53, respectively. The second area 50 is positioned between the two first areas 48 in lateral directions and thus, the first connecting structures 52 and the second connecting structures 53 are provided between two flat surface areas.

In order to fix the power semiconductor module 12 to the cooler 14, an adhesive 54 is provided at least in part at the first area 48 and at the second area 50 for fixing the first connecting area 41 to the second connecting area 46.

It is further shown that the substrate 22 or the metallization 34 and the baseplate 16 are connected to each other by means of a bond line 23, which may be a solder, or an adhesive, for example. However, a sintered embodiment is also possible.

With regard to the first connecting structures 52 and the second connecting structures 53, these are in more detail shown in Figures 2 and 3 which show respective details of Figure 1. The first connection structure 52 being arranged opposite the second connecting structure 53. Further, it can be seen that the first connecting structure 52 of the power semiconductor module 12 is provided within the baseplate 16.

An example not falling under the scope for which protection is sought is shown in Figure 2 in which it is disclosed that the first connecting structure 52 comprises recessions 56 and in that the second connecting structure 53 comprises protrusions 58, being located opposite to the recessions 56. Alternatively or additionally, it may be provided that the first connecting structure 52 comprises protrusions 58 and in that the second connecting structure 53 comprises corresponding recessions 56 like shown in Figure 3, a further example also not falling under the scope for which protection is sought.

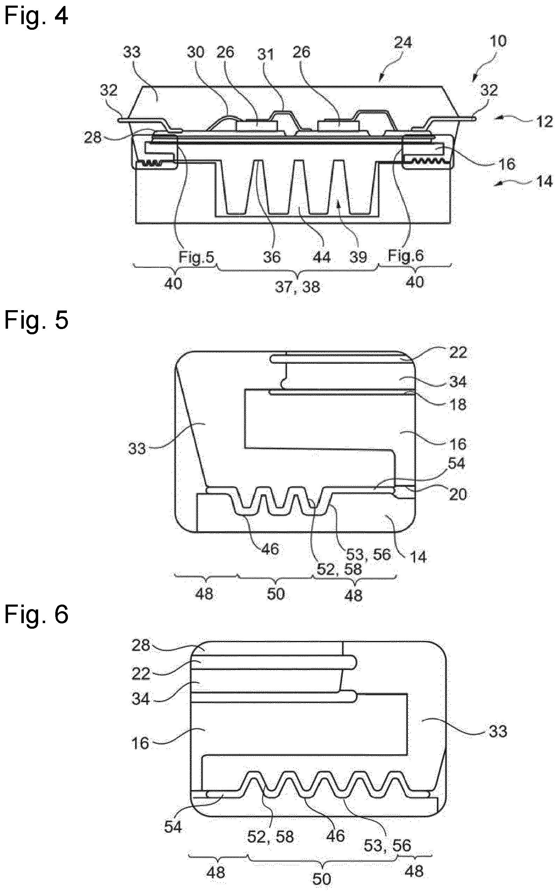

An embodiment of an arrangement for which protection is sought is shown in Figure 4.

According to this exemplary embodiment the first connecting structures 52 are provided in the mold compound 33. The further arrangement of the connecting structures 52, 53, however, might be realized comparable to Figures 1 to 3.

With this regard, an exemplary embodiment is shown in Figure 5 in which it is disclosed that the first connecting structure 52 comprises recessions 56 and in that the second connecting structure 53 comprises protrusions 58. Alternatively or additionally, it may be provided that the first connecting structure 52 comprises protrusions 58 and in that the second connecting structure 53 comprises corresponding recessions 56 like shown in Figure 6. Even though these exemplary embodiments are shown in one baseplate 14, it may be provided that the cooling surface 36 comprises both exemplary embodiments or only one exemplary embodiment.

The protrusions may thereby generally have any suitable form, such as a square, rectangle, triangle, trapezium, etc.

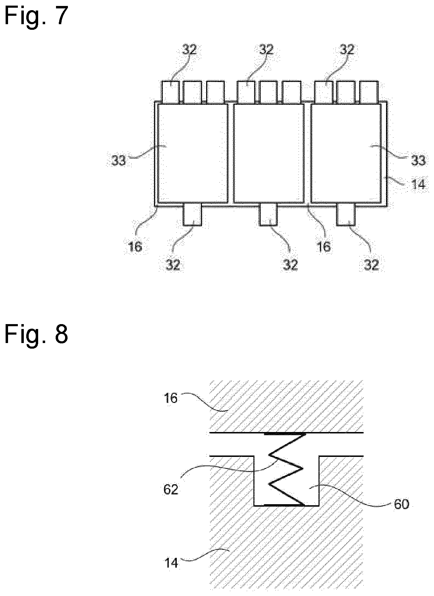

Figure 7 shows a top view of an inverter in which it is indicated that the mold compound 33 is fixed to the cooler 14 by cooling structures 52, 53 with an adhesive 54.

Figure 8 not falling under the scope for which protection is sought shows that the cooler 14 and in more detail the cooling channel 44 comprises a recess 60 for receiving a spring 62, the spring 62 being in contact with the baseplate 16 and the cooler 14. This helps electrically contacting the baseplate 16 and the cooler 14 in case both of them lie on the same potential.

While the disclosure has been illustrated and described in detail in the drawings and foregoing description, such illustration and description are to be considered illustrative or exemplary and not restrictive; the disclosure is not limited to the disclosed embodiments.

Any reference signs in the claims should not be construed as limiting the scope.

### Reference signs list

- 10: arrangement
- 12: power semiconductor module
- 14: cooler
- 16: baseplate
- 18: first side
- 20: second side
- 22: substrate
- 23: bond line
- 24: electrical circuit
- 26: power semiconductor device
- 28: metallization
- 30: bond wire
- 32: terminal
- 33: mold compound
- 34: further metallization
- 36: cooling surface
- 37: cooling area
- 38: inner area
- 39: cooling structure
- 40: outer area
- 41: first connecting area
- 44: cooling channel
- 46: second connecting area
- 48: first area
- 50: second area
- 52: first connecting structure
- 53: second connecting structure
- 54: adhesive
- 56: recession
- 58: protrusion
- 60: recess
- 62: spring

## Claims

1. An arrangement (10) comprising a power semiconductor module (12), a cooler (14) for cooling the power semiconductor module (12), and an adhesive (54) for fixing the cooler (14) to the power semiconductor module (12), wherein
the power semiconductor module (12) comprises a baseplate (16), wherein
the power semiconductor module (12) further comprises a cooling structure (39) with a cooling surface (36), wherein the cooling surface (36) faces the cooler (14) for dissipating heat from the baseplate (16) and the cooling structure is at least in part formed from the baseplate (16), wherein
the cooling structure (39) comprises an inner area (38) and an outer area (40) surrounding the inner area (38) at least in part in lateral directions and comprising a first connecting area (41) in the outer area (40), wherein
the first connecting area (41) is connected to a second connecting area (46) of the cooler (14) via the adhesive (54), wherein
the first connecting area (41) comprises a first connecting structure (52) and the second connecting area (46) comprises a second connecting structure (53), wherein
the first connection structure (52) is arranged opposite to the second connecting structure (53), wherein at least one of
the first connecting structure (52) comprises at least one recession (56) and the second connecting structure (53) comprises at least one protrusion (58), and
the second connecting structure (53) comprises at least one recession (56) and the first connecting structure (52) comprises at least one protrusion (58), wherein
the at least one protrusion and the at least one recession are arranged such that the at least one protrusion is arranged in the at least one recession, wherein
the adhesive (54) is placed between the first connecting structure (52) and the second connecting structure (53), and wherein
the first connecting area (41) is part of a mold compound (33) arranged on the baseplate (16).

2. The arrangement (10) according to the previous claim, wherein at least one of the first connecting area (41) and the second connecting area (46) comprises a flat surface area.

3. The arrangement (10) according to any of the previous claims, wherein at least one of the first connecting structure (52) and the second connecting structure (53) form a closed path surrounding the inner area (38) completely in lateral directions.

4. The arrangement (10) according to any of the previous claims, wherein the first connecting area (41) comprises a plurality of first connecting structures (52) and the second connecting area (46) comprises a plurality of second connecting structures (53), wherein the first connecting structures (52) and the second connecting structures (53) are aligned differently.

5. The arrangement (10) according to any of the previous claims, wherein the cooler (14) comprises an inlet port and an outlet port, and wherein the cooler (14) comprises a cooling channel (44) for guiding a coolant between the inlet port and the outlet port within the inner area (38).

6. The arrangement (10) according to the previous claim, wherein the cooling structure (39) is arranged within the cooling channel (44).

7. A method for forming an arrangement according to any of the previous claims, the method comprising:
a) providing an arrangement (10) comprising a power semiconductor module (12), a cooler (14) for cooling the power semiconductor module (12), and an adhesive (54) for fixing the cooler (14) to the power semiconductor module (12), wherein
the power semiconductor module (12) comprises a baseplate (16), wherein
the power semiconductor module (12) further comprises a cooling structure (39) with a cooling surface (36), wherein the cooling surface (36) faces the cooler (14) for dissipating heat from the baseplate (16) and the cooling structure is at least in part formed from the baseplate (16), wherein
the cooling structure (39) comprises an inner area (38) and an outer area (40) surrounding the inner area (38) at least in part in lateral directions and comprising a first connecting area (41) in the outer area (40), wherein
the first connecting area (41) comprises a first connecting structure (52) and the second connecting area (46) comprises a second connecting structure (53), and wherein
the first connecting area (41) is part of a mold compound (33) arranged on the baseplate (16),
and
b) applying an adhesive at least in part to at least one of the first connecting structure (52) at the first connecting area (41) and at the second connecting structure at the second connecting area (46) for fixing the first connecting area (41) to the second connecting area (46), wherein
the first connection structure (52) is arranged opposite to the second connecting structure (53), wherein at least one of
the first connecting structure (52) comprises at least one recession (56) and the second connecting structure (53) comprises at least one protrusion (58), and
the second connecting structure (53) comprises at least one recession (56) and the first connecting structure (52) comprises at least one protrusion (58), and wherein
the at least one protrusion and the at least one recession are arranged such that the at least one protrusion is arranged in the at least one recession.

8. The method according to claim 7, wherein before applying an adhesive according to step b), roughening at least one of a first area of the first connecting area (41) and a first area of the second connecting area (46).

9. The method according to claim 8, **characterized in that** the roughening is performed with at least one of a chemical process and a physical process.

## Patentansprüche

1. Anordnung (10), umfassend ein Leistungshalbleitermodul (12), einen Kühler (14) zum Kühlen des Leistungshalbleitermoduls (12) und einen Klebstoff (54) zum Fixieren des Kühlers (14) an dem Leistungshalbleitermodul (12), wobei
das Leistungshalbleitermodul (12) eine Basisplatte (16) umfasst, wobei
das Leistungshalbleitermodul (12) des Weiteren eine Kühlstruktur mit einer Kühloberfläche (36) umfasst, wobei die Kühloberfläche (36) zu dem Kühler (14) weist, um Wärme von der Basisplatte (16) abzuführen, und die Kühlstruktur mindestens teilweise aus der Basisplatte (16) gebildet ist, wobei
die Kühlstruktur (39) einen Innenbereich (38) und einen Außenbereich umfasst, der den Innenbereich (38) mindestens teilweise in lateralen Richtungen umgibt und einen ersten Verbindungsbereich (41) in dem Außenbereich (40) umfasst, wobei
der erste Verbindungsbereich (41) mittels des Klebstoffs (54) mit einem zweiten Verbindungsbereich (46) des Kühlers (14) verbunden ist, wobei
der erste Verbindungsbereich (41) eine erste Verbindungsstruktur (52) umfasst, und der zweite Verbindungsbereich (46) eine zweite Verbindungsstruktur (53) umfasst, wobei
die erste Verbindungsstruktur (52) gegenüber der zweiten Verbindungsstruktur (53) angeordnet ist, wobei mindestens eines der folgenden zutrifft:
die erste Verbindungsstruktur (52) umfasst mindestens eine Vertiefung (56), und die zweite Verbindungsstruktur (53) umfasst mindestens einen Vorsprung (58), und
die zweite Verbindungsstruktur (53) umfasst mindestens eine Vertiefung (56), und die erste Verbindungsstruktur (52) umfasst mindestens einen Vorsprung (58), wobei der mindestens eine Vorsprung und die mindestens eine Vertiefung so angeordnet sind, dass der mindestens eine Vorsprung in der mindestens einen Vertiefung angeordnet ist, wobei
der Klebstoff (54) zwischen der ersten Verbindungsstruktur (52) und der zweiten Verbindungsstruktur (53) platziert ist, und wobei
der erste Verbindungsbereich (41) Teil einer Formungsmasse (33) ist, die auf der Basisplatte (16) angeordnet ist.

2. Anordnung (10) nach einem der vorhergehenden Ansprüche, wobei mindestens einer von dem ersten Verbindungsbereich (41) und dem zweiten Verbindungsbereich (46) eine flache Oberfläche umfasst.

3. Anordnung (10) nach einem der vorhergehenden Ansprüche, wobei mindestens eine von der ersten Verbindungsstruktur (52) und der zweiten Verbindungsstruktur (53) einen geschlossenen Pfad bildet, der den Innenbereich (38) in lateralen Richtungen vollständig umgibt.

4. Anordnung (10) nach einem der vorhergehenden Ansprüche, wobei der erste Verbindungsbereich (41) eine Vielzahl von ersten Verbindungsstrukturen (52) umfasst, und der zweite Verbindungsbereich (46) eine Vielzahl von zweiten Verbindungsstrukturen (53) umfasst, wobei die ersten Verbindungsstrukturen (52) und die zweiten Verbindungsstrukturen (53) unterschiedlich ausgerichtet sind.

5. Anordnung (10) nach einem der vorhergehenden Ansprüche, wobei der Kühler (14) einen Einlassanschluss und einen Auslassanschluss umfasst, und wobei der Kühler (14) einen Kühlkanal (44) zum Lenken eines Kühlmittels zwischen dem Einlassanschluss und dem Auslassanschluss innerhalb des Innenbereichs (38) umfasst.

6. Anordnung (10) nach einem der vorhergehenden Ansprüche, wobei die Kühlstruktur (39) innerhalb des Kühlkanals (44) angeordnet ist.

7. Verfahren zur Bildung einer Anordnung nach einem der vorhergehenden Ansprüche, wobei das Verfahren umfasst:
a) Bereitstellen einer Anordnung (10), umfassend ein Leistungshalbleitermodul (12), einen Kühler (14) zum Kühlen des Leistungshalbleitermoduls (12) und einen Klebstoff (54) zum Fixieren des Kühlers (14) an dem Leistungshalbleitermodul (12), wobei
das Leistungshalbleitermodul (12) eine Basisplatte (16) umfasst, wobei
das Leistungshalbleitermodul (12) des Weiteren eine Kühlstruktur (39) mit einer Kühloberfläche (36) umfasst, wobei die Kühloberfläche (36) zu dem Kühler (14) weist, um Wärme von der Basisplatte (16) abzuführen, und die Kühlstruktur mindestens teilweise aus der Basisplatte (16) gebildet ist, wobei
die Kühlstruktur (39) einen Innenbereich (38) und einen Außenbereich (40) umfasst, die den Innenbereich (38) mindestens teilweise in lateralen Richtungen umgibt und einen ersten Verbindungsbereich (41) in dem Außenbereich (40) umfasst, wobei
der erste Verbindungsbereich (41) eine erste Verbindungsstruktur (52) umfasst, und der zweite Verbindungsbereich (46) eine zweite Verbindungsstruktur (53) umfasst, und wobei
der erste Verbindungsbereich (41) Teil einer Formungsmasse (33) ist, die auf der Basisplatte (16) angeordnet ist, und
b) Aufbringen eines Klebstoffs mindestens teilweise auf mindestens eine von der ersten Verbindungsstruktur (52) an dem ersten Verbindungsbereich (41) und an der zweiten Verbindungsstruktur an dem zweiten Verbindungsbereich (46) zum Fixieren des ersten Verbindungsbereichs (41) an dem zweiten Verbindungsbereich (46), wobei die erste Verbindungsstruktur (52) gegenüber der zweiten Verbindungsstruktur (53) angeordnet ist, wobei mindestens eines der folgenden zutrifft:
die erste Verbindungsstruktur (52) umfasst mindestens eine Vertiefung (56), und die zweite Verbindungsstruktur (53) umfasst mindestens einen Vorsprung (58), und
die zweite Verbindungsstruktur (53) umfasst mindestens eine Vertiefung (56), und die erste Verbindungsstruktur (52) umfasst mindestens einen Vorsprung (58), und wobei der mindestens eine Vorsprung und die mindestens eine Vertiefung so angeordnet sind, dass mindestens ein Vorsprung in der mindestens einen Vertiefung angeordnet ist.

8. Verfahren nach Anspruch 7, wobei vor dem Aufbringen eines Klebstoffs gemäß Schritt b) mindestens einer von einem ersten Bereich des ersten Verbindungsbereichs (41) und einem ersten Bereich des zweiten Verbindungsbereichs (46) aufgeraut wird.

9. Verfahren nach Anspruch 8, **dadurch gekennzeichnet, dass** das Aufrauen mit mindestens einem von einem chemischen Prozess und einem physikalischen Prozess durchgeführt wird.

## Revendications

1. Agencement (10) comprenant un module semi-conducteur de puissance (12), un refroidisseur (14) pour refroidir le module semi-conducteur de puissance (12), et un adhésif (54) pour fixer le refroidisseur (14) au module semi-conducteur de puissance (12),
le module semi-conducteur de puissance (12) comprenant une plaque de base (16),
le module semi-conducteur de puissance (12) comprenant en outre une structure de refroidissement (39) avec une surface de refroidissement (36), la surface de refroidissement (36) faisant face au refroidisseur (14) pour dissiper la chaleur de la plaque de base (16) et la structure de refroidissement étant au moins en partie formée à partir de la plaque de base (16),
la structure de refroidissement (39) comprenant une zone intérieure (38) et une zone extérieure (40) entourant la zone intérieure (38) au moins en partie dans les directions latérales et comprenant une première zone de connexion (41) dans la zone extérieure (40),
la première zone de connexion (41) étant reliée à une deuxième zone de connexion (46) du refroidisseur (14) par l'intermédiaire de l'adhésif (54),
la première zone de connexion (41) comprenant une première structure de connexion (52) et la deuxième zone de connexion (46) comprenant une deuxième structure de connexion (53),
la première structure de connexion (52) étant agencée à l'opposé de la deuxième structure de connexion (53), au moins l'un parmi :
la première structure de connexion (52) comprenant au moins un renfoncement (56) et la deuxième structure de connexion (53) comprenant au moins une protubérance (58), et
la deuxième structure de connexion (53) comprenant au moins un renfoncement (56) et la première structure de connexion (52) comprenant au moins une protubérance (58),
l'au moins une protubérance et l'au moins un renfoncement étant agencés de telle sorte que l'au moins une protubérance est agencée dans l'au moins un renfoncement,
l'adhésif (54) étant placé entre la première structure de connexion (52) et la deuxième structure de connexion (53), et
la première zone de connexion (41) faisant partie d'un composé de moulage (33) agencé sur la plaque de base (16).

2. Agencement (10) selon la revendication précédente, au moins l'une de la première zone de connexion (41) et de la deuxième zone de connexion (46) comprenant une surface plane.

3. Agencement (10) selon l'une quelconque des revendications précédentes, au moins l'une de la première structure de connexion (52) et de la deuxième structure de connexion (53) formant un chemin fermé entourant la zone intérieure (38) complètement dans les directions latérales.

4. Agencement (10) selon l'une quelconque des revendications précédentes, la première zone de connexion (41) comprenant une pluralité de premières structures de connexion (52) et la deuxième zone de connexion (46) comprenant une pluralité de deuxièmes structures de connexion (53), les premières structures de connexion (52) et les deuxièmes structures de connexion (53) étant alignées différemment.

5. Agencement (10) selon l'une quelconque des revendications précédentes, le refroidisseur (14) comprenant un port d'entrée et un port de sortie, et le refroidisseur (14) comprenant un canal de refroidissement (44) pour guider un liquide de refroidissement entre le port d'entrée et le port de sortie à l'intérieur de la zone intérieure (38).

6. Agencement (10) selon la revendication précédente, la structure de refroidissement (39) étant agencée à l'intérieur du canal de refroidissement (44).

7. Procédé de formation d'un agencement selon l'une quelconque des revendications précédentes, le procédé comprenant :
a) la fourniture d'un agencement (10) comprenant un module semi-conducteur de puissance (12), un refroidisseur (14) pour refroidir le module semi-conducteur de puissance (12), et un adhésif (54) pour fixer le refroidisseur (14) au module semi-conducteur de puissance (12),
le module semi-conducteur de puissance (12) comprenant une plaque de base (16),
le module semi-conducteur de puissance (12) comprenant en outre une structure de refroidissement (39) avec une surface de refroidissement (36), la surface de refroidissement (36) faisant face au refroidisseur (14) pour dissiper la chaleur de la plaque de base (16) et la structure de refroidissement étant au moins en partie formée à partir de la plaque de base (16),
la structure de refroidissement (39) comprenant une zone intérieure (38) et une zone extérieure (40) entourant la zone intérieure (38) au moins en partie dans les directions latérales et comprenant une première zone de connexion (41) dans la zone extérieure (40),
la première zone de connexion (41) comprenant une première structure de connexion (52) et la deuxième zone de connexion (46) comprenant une deuxième structure de connexion (53), et
la première zone de connexion (41) faisant partie d'un composé de moulage (33) agencé sur la plaque de base (16),
et
b) l'application d'un adhésif au moins en partie sur au moins une de la première structure de connexion (52) au niveau de la première zone de connexion (41) et sur la deuxième structure de connexion au niveau de la deuxième zone de connexion (46) pour fixer la première zone de connexion (41) à la deuxième zone de connexion (46),
la première structure de connexion (52) étant agencée à l'opposé de la deuxième structure de connexion (53), au moins l'un des éléments parmi :
la première structure de connexion (52) comprenant au moins un renfoncement (56) et la deuxième structure de connexion (53) comprenant au moins une protubérance (58), et
la deuxième structure de connexion (53) comprenant au moins un renfoncement (56) et la première structure de connexion (52) comprenant au moins une protubérance (58), et
l'au moins une protubérance et l'au moins un renfoncement étant agencés de telle sorte que l'au moins une protubérance est agencée dans l'au moins un renfoncement.

8. Procédé selon la revendication 7, avant l'application d'un adhésif selon l'étape b), le dépolissage d'au moins une d'une première zone de la première zone de connexion (41) et d'une première zone de la deuxième zone de connexion (46).

9. Procédé selon la revendication 8, **caractérisé en ce que** le dépolissage est réalisé avec au moins un procédé parmi un procédé chimique et un procédé physique.
